(19) Europäisches Patentamt
European Patent Office
Office européen des brevets

(11) **EP 4 501 495 A1**

(12) **EUROPEAN PATENT APPLICATION**
published in accordance with Art. 153(4) EPC

(43) Date of publication:
**05.02.2025 Bulletin 2025/06**

(21) Application number: **23781032.0**

(22) Date of filing: **31.03.2023**

(51) International Patent Classification (IPC):
**B22F 1/00** *(2022.01)*  **B22F 1/054** *(2022.01)*
**B22F 1/06** *(2022.01)*  **B22F 1/07** *(2022.01)*
**B22F 1/102** *(2022.01)*  **B22F 1/103** *(2022.01)*
**B22F 1/16** *(2022.01)*  **B22F 7/08** *(2006.01)*
**B22F 9/00** *(2006.01)*  **B22F 9/20** *(2006.01)*
**B82Y 30/00** *(2011.01)*  **B82Y 40/00** *(2011.01)*
**C22C 1/04** *(2023.01)*  **C22C 32/00** *(2006.01)*
**H01L 21/52** *(2006.01)*

(52) Cooperative Patent Classification (CPC):
**B22F 1/00; B22F 1/054; B22F 1/06; B22F 1/07;**
**B22F 1/102; B22F 1/103; B22F 1/16; B22F 7/08;**
**B22F 9/00; B22F 9/20; B82Y 30/00; B82Y 40/00;**
**C22C 1/04; C22C 32/00; H01L 21/52**

(86) International application number:
**PCT/JP2023/013460**

(87) International publication number:
**WO 2023/191024 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.03.2022 JP 2022061331**
**19.10.2022 JP 2022167366**
**19.10.2022 JP 2022167371**

(71) Applicant: **Kyocera Corporation**
**Kyoto-shi, Kyoto 612-8501 (JP)**

(72) Inventors:
• **NONOMURA, Kouki**
**Kyoto-shi, Kyoto 612-8501 (JP)**
• **KIKUCHI, Tomonao**
**Kyoto-shi, Kyoto 612-8501 (JP)**

(74) Representative: **Viering, Jentschura & Partner
mbB**
**Patent- und Rechtsanwälte**
**Am Brauhaus 8**
**01099 Dresden (DE)**

(54) **OXIDE-CONTAINING PLATE-LIKE COPPER PARTICLES, PASTE COMPOSITION, SEMICONDUCTOR DEVICE, ELECTRICAL COMPONENT AND ELECTRONIC COMPONENT**

(57) Provided are an oxide-containing plate-shaped copper particle that can provide a paste composition capable of forming a bonding layer having high denseness, high bonding strength, and high bonding reliability, a paste composition using the same, and a semiconductor device, an electrical component, and an electronic component. The copper oxide-containing plate-shaped copper particle of the present disclosure contains Cu, $Cu_2O$, and $Cu_{64}O$, wherein a content of $Cu_{64}O$ is from 2.1 to 25.0 mass% relative to 100 mass% of a total content of Cu, $Cu_2O$, and $Cu_{64}O$.

EP 4 501 495 A1

## Description

TECHNICAL FIELD

The present disclosure relates to an oxide-containing plate-shaped copper particle, a paste composition using the same, and a semiconductor device, an electrical component, and an electronic component.

BACKGROUND OF INVENTION

In semiconductor devices and various electrical components and electronic components, a highly thermally conductive paste is used as an adhesive for bonding members. In a semiconductor device, heat generation is increased due to high integration and high-speed operation. A countermeasure for obtaining stable operability is adopted, for example, in which a heat generating member such as a semiconductor element and a heat dissipating member are bonded to each other with a highly thermally conductive adhesive (paste), whereby heat is dissipated. An electrically conductive paste having high thermal conductivity is used in die bonding of a bare chip, adhesion of an LED chip, adhesion between an electrode and a lead wire, and the like.

As one of electrically conductive pastes having high thermal conductivity, a paste composition containing a copper particle has been proposed. Application of such a paste composition to printed electronics has also been studied. For example, Patent Documents 1 and 2 disclose that an oxide-containing copper particle obtained by sintering a copper raw material at a low temperature is used as a constituent material for an electrically conductive paste.

CITATION LIST

PATENT LITERATURE

    Patent Document 1: JP 2020-29392 A
    Patent Document 2: WO 2022/045252

SUMMARY

The present disclosure relates to the following:

    [1] A copper oxide-containing plate-shaped copper particle containing Cu, $Cu_2O$, and $Cu_{64}O$, wherein a content of $Cu_{64}O$ is from 2.1 to 25.0 mass% relative to 100 mass% of a total content of Cu, $Cu_2O$ and $Cu_{64}O$.

BRIEF DESCRIPTION OF THE DRAWINGS

    FIG. 1 is a scanning electron microscope observation image of the oxide-containing plate-shaped copper particle of Example 4.
    FIG. 2 is a scanning electron microscope observation image of the oxide-containing copper particle of Comparative Example 2.

DESCRIPTION OF EMBODIMENTS

The electrically conductive pastes including the oxide-containing copper particle, as described in Patent Documents 1 and 2, are substantially spherical particles. For this reason, when bonding is performed by sintering, there is a possibility that vacancies are generated in the bonding layer, resulting in low denseness, difficulty in obtaining sufficient bonding strength, and low bonding reliability.

The present disclosure relates to an oxide-containing copper particle that can provide a paste composition capable of forming a bonding layer having high denseness, high bonding strength, and high bonding reliability, a paste composition including the same, and a semiconductor device, an electrical component, and an electronic component.

Hereinafter, the present disclosure will be described in detail with reference to an embodiment.

The oxide-containing plate-shaped copper particle in the present disclosure refers to a particle containing metallic copper and at least one copper oxide, and having a plate-shaped particle shape. Hereinafter, it is also simply referred to as copper particle.

In the present description, wording of "from XX to YY" refers to "not less than XX and not more than YY". In the present description, with regard to numerical ranges (e.g., ranges such as content), lower and upper limit values described in a stepwise manner may each be independently combined. In a numerical range described herein, the upper or lower limit value of the numerical range may be replaced by a value presented in the examples.

Oxide-Containing Plate-Shaped Copper Particle

The oxide-containing plate-shaped copper particle of the present disclosure contains Cu, $Cu_2O$, and $Cu_{64}O$, in which a content of $Cu_{64}O$ is from 2.1 to 25.0 mass% relative to 100 mass% of a total content of Cu, $Cu_2O$, and $Cu_{64}O$.

The copper particle of the present disclosure contains Cu and copper oxides, $Cu_2O$ and $Cu_{64}O$, and has good sinterability and reducibility. The content of $Cu_{64}O$ in the copper particle falling within the above range makes it possible to obtain a paste composition capable of forming a bonding layer having high denseness, high bonding strength, and high bonding reliability.

$Cu_{64}O$ has a lower proportion of oxygen atoms and lower phase stability than CuO and $Cu_2O$. Therefore, it is considered that, when the copper particle has a high content of $Cu_{64}O$, it is likely to undergo self-oxidative decomposition at the time of sintering and unlikely to be reduced, and, on the other hand, copper atoms constituting $Cu_{64}O$ are likely to move or diffuse by heating, leading to promotion of sintering.

When the content of $Cu_{64}O$ is not less than 2.1 mass%, sintering is easily promoted due to movement or diffusion of the copper atoms constituting $Cu_{64}O$. In addition, when the content of $Cu_{64}O$ is not more than 25.0 mass%, $Cu_{64}O$ is sufficiently reduced, and copper particles having good sinterability are obtained.

The content of $Cu_{64}O$ may be from 2.5 to 25.0 mass%, or may be from 3.0 to 20.0 mass%.

The copper particle contains $Cu_2O$, and a content thereof may be not more than 5.0 mass%, from 0.1 to 4.5 mass%, or from 1.0 to 4.0 mass% relative to 100 mass% of the total content of Cu, $Cu_2O$, and $Cu_{64}O$ from the viewpoint of good sinterability of the copper particle.

Each of the contents of $Cu_{64}O$ and $Cu_2O$ relative to 100 mass% of the total content of Cu, $Cu_{64}O$ and $Cu_2O$ in the copper particle is determined from an X-ray diffraction (XRD) pattern by a reference intensity ratio (RIR) method. The XRD pattern is obtained by performing XRD measurement by irradiation with characteristic X-rays of $CuK\alpha$ rays (wave length: 0.15418 nm). Specifically, the measurement is performed by the method described in the Examples. In the XRD pattern, each content can be calculated by the RIR method using an integrated intensity obtained by subtracting a background intensity and each RIR value (Cu: 8.86, $Cu_{64}O$: 4.89, $Cu_2O$: 8.28) for the strongest curve of each component (Cu (111), $Cu_{64}O$ (044), and $Cu_2O$ (111)). A diffraction angle $2\theta$ of each peak is 43.298° for Cu (111), 40.710° for $Cu_{64}O$ (044), and 36.419° for $Cu_2O$ (111).

When the copper particle is heated at 200°C in a nitrogen atmosphere, a ratio (C2/C1) of a crystallite diameter (C2) of Cu (111) after heating to a crystallite diameter (C1) of Cu (111) before heating may be not less than 2.0. That is, the ratio C2/C1 between the crystallite diameters of Cu (111) before and after heating at 200°C in a nitrogen atmosphere may be not less than 2.0, from 3.0 to 10.0, or from 4.0 to 8.0 from the viewpoint of sinterability, denseness, and bonding strength.

The heating at 200°C in a nitrogen atmosphere is performed under heating conditions in consideration of an atmosphere and a temperature in a case where a paste composition including the copper particle is used as a bonding material and bonding is performed by sintering the copper particles from a practical viewpoint.

The crystallite diameter (C2) may be not less than 55.0 nm, may be from 57.0 to 80.0 nm, or may be from 58.0 to 75.0 nm from the viewpoint of sinterability, denseness, and bonding strength.

The crystallite diameter (C1) may be from 5.0 to 30.0 nm, may be from 7.0 to 25.0 nm, or may be from 8.0 to 20.0 nm from the viewpoint of sinterability, denseness, and bonding strength.

The crystallite diameter of Cu (111) of the copper particle is determined from the XRD pattern. Specifically, the crystallite diameter is determined by the method described in the Examples.

The copper particle may be a plate-shaped particle.

The copper particle may have a thickness of from 5 to 50 nm, from 8 to 40 nm, or from 10 to 30 nm.

The copper particle may have a major axis of from 30 to 300 nm, from 50 to 200 nm, or from 75 to 150 nm, and the major axis may be larger than the thickness.

The copper particle may have an aspect ratio (major axis/thickness) of from 1.5 to 10.0, from 2.0 to 9.0, or from 3.0 to 8.0.

Since the copper particle is the plate-shaped particle as described above, a contact area between the particles is larger than that of spherical particles. It is presumed that a bonding layer formed from a paste composition including the plate-shaped particle as described above is likely to have high denseness, high bonding strength, and high bonding reliability.

Each of the thickness and major axis of the copper particle is a median of length measurement values of at least 200 particles extracted from an image captured in scanning electron microscope (SEM) observation. The thickness and major axis of the copper particle can be specifically measured by methods which will be described in the Examples. The plate-shaped particle has a shape having a pair of substantially parallel planes, and a distance between the pair of planes is referred to as "thickness", and the longest diameter in the planes is referred to as "major axis".

The copper particle is usually sintered by heating to from 100 to 250°C in an inert gas atmosphere.

Examples of the inert gas include nitrogen, argon, and helium. From the viewpoint of availability and cost, nitrogen may be used.

A heating temperature may be from 120 to 230°C or from 150 to 200°C, from the viewpoint of good sinterability.

The sintering may be performed under normal pressure or under pressure.

A heating time is appropriately set according to the heating temperature, a form of a sintered body, and the like. From the viewpoint of sufficient progress of the sintering, a sintering time may be, for example, from 5 to 180 minutes, from 10 to 120 minutes, or from 30 to 90 minutes.

Method for Producing Oxide-Containing Plate-Shaped Copper Particle A method for producing the oxide-containing plate-shaped copper particle of the present disclosure is not particularly limited. For example, a copper compound may be reduced with a reducing compound in the presence of a shape stabilizer. The copper compound, the shape stabilizer, and the reducing compound may be mixed in an organic solvent.

Copper Compound

Examples of the copper compound include copper oxide, copper hydroxide, copper nitride, and copper carboxylate. The copper compound may be copper oxide from the viewpoint of obtaining the copper particle of the present disclosure at a high yield. The copper compounds may be used alone or in combination of two or more.

Examples of the copper oxide include copper (I) oxide (cuprous oxide: $Cu_2O$) and copper (II) oxide (CuO). From the viewpoint of productivity, copper (I) oxide may be used. Examples of the copper hydroxide include copper (II) hydroxide and copper (I) hydroxide. Examples of the copper nitride include copper (II) nitride and copper (I) nitride.

Examples of the copper carboxylate include copper carboxylate anhydrides or copper carboxylate hydrates such as copper (I) formate, copper (I) acetate, copper (I) propionate, copper (I) butyrate, copper (I) valerate, copper (I) hexanoate, copper (I) octoate, and copper (I) decanoate, and copper (II) formate, copper (II) acetate, copper (II) propionate, copper (II) butyrate, copper (II) valerate, copper (II) hexanoate, copper (II) octoate, copper (II) decanoate, and copper (II) citrate. As the copper carboxylate, a commercially available copper carboxylate may be used. A copper carboxylate synthesized by a known method may be used. The copper carboxylate may be copper (II) acetate monohydrate from the viewpoints of availability and a production efficiency of the copper particle of the present disclosure.

Shape Stabilizer

The shape stabilizer may be, for example, at least one selected from the group consisting of an amine compound, a carboxylic acid, and a phosphoric acid ester, or may be a combination of an amine compound and a carboxylic acid.

Due to the shape stabilizer covering at least a part of oxide-containing copper which is the copper particle of the present disclosure, the predetermined light absorption characteristic of the present disclosure is easily obtained. In addition, fluidity of a paste composition including the copper particle is improved.

Examples of the amine compound include monoamines such as dipropylamine, butylamine, dibutylamine, hexylamine, cyclohexylamine, heptylamine, octylamine, nonylamine, decylamine, 3-aminopropyltriethoxysilane, dodecylamine, oleylamine, monoethanolamine, 2-aminoethoxy-2-ethanol, 3-amino-1-propanol, 3-amino-2-propanol, 4-amino-1-butanol, 3-amino-1-hexanol, and 2-(2-aminoethoxy)ethanol; and diamines such as ethylenediamine, N,N-dimethylethylenediamine, N,N'-dimethylethylenediamine, N,N-diethylethylenediamine, N,N'-diethylethylenediamine, 1,3-propanediamine, 2,2-dimethyl-1,3-propanediamine, N,N-dimethyl-1,3-diaminopropane, N,N'-dimethyl-1,3-diaminopropane, N,N-diethyl-1,3-diaminopropane, 1,4-diaminobutane, 1,5-diamino-2-methylpentane, 1,6-diaminohexane, N,N'-dimethyl-1,6-diaminohexane, 1,7-diaminoheptane, and 1,8-diaminooctane. The amine compounds may be used alone or in combination of two or more. The amine compound may be an amino alcohol, and the amino alcohol may have a molecular weight of not less than 80 and not more than 150.

Examples of the carboxylic acid include monocarboxylic acids such as formic acid, acetic acid, propionic acid, butyric acid, valeric acid, hexanoic acid, heptanoic acid, octanoic acid, octylic acid, nonanoic acid, decanoic acid, oleic acid, stearic acid, and isostearic acid; and dicarboxylic acids such as oxalic acid, malonic acid, succinic acid, glutaric acid, adipic acid, pimelic acid, suberic acid, azelaic acid, sebacic acid, and diglycolic acid. The carboxylic acid may be an aromatic carboxylic acid such as benzoic acid, phthalic acid, isophthalic acid, terephthalic acid, salicylic acid, or gallic acid, or may be a hydroxy acid such as glycolic acid, lactic acid, tartronic acid, malic acid, glyceric acid, hydroxybutyric acid, tartaric acid, citric acid, or isocitric acid. The carboxylic acids may be used alone or in combination of two or more. The carboxylic acid may be a monocarboxylic acid. The monocarboxylic acid may have a molecular weight of not less than 80 and not more than 150.

The phosphoric acid ester can remove an oxide film generated on a surface of the copper particle by heating in the air and can enhance the sinterability of the copper particle. Also, the phosphoric acid ester can enhance lubricity of the copper particle in the paste composition. The phosphoric acid ester may be added after a reduction reaction.

Examples of the phosphoric acid ester include alkyl phosphates, polyoxyethylene alkyl ether phosphates, and polyoxyethylene alkyl phenyl ether phosphates. The phosphoric acid ester may have an acid value and an amine value each being not more than 130 mgKOH/g, not more than 120 mgKOH/g, or not more than 110 mgKOH/g. The phosphoric acid ester may have a ratio of the acid value to the amine value [acid value/amine value] of from 0 to 1.5 or from 0 to 1.2.

The acid value is determined by a method in accordance with JIS K 0070:1992, and the amine value is determined by a method in accordance with JIS K 7237:1995.

A total amount of the shape stabilizer to be used may be from 0.1 to 10 mol, from 0.5 to 8 mol, or from 1 to 5 mol with respect to 1 mol of the copper compound.

For example, when an amine compound and a carboxylic acid are used as the shape stabilizers, a blending molar ratio of the amine compound to the carboxylic acid may be from 1/5 to 5/1, from 1/3 to 3/1, or from 1/2 to 2/1.

Reducing Compound

The reducing compound is a compound having a reducing power to reduce the copper compound, thereby releasing metallic copper, and is not particularly limited. Examples of the reducing compound include hydrazine derivatives. The reducing compounds may be used alone or in combination of two or more.

Examples of the hydrazine derivative include hydrazine monohydrate, methylhydrazine, ethylhydrazine, n-propylhydrazine, isopropylhydrazine, n-butylhydrazine, isobutylhydrazine, sec-butylhydrazine, tert-butylhydrazine, n-pentylhydrazine, isopentylhydrazine, neo-pentylhydrazine, tert-pentylhydrazine, n-hexylhydrazine, isohexylhydrazine, n-heptylhydrazine, n-octylhydrazine, n-nonylhydrazine, n-decylhydrazine, n-undecylhydrazine, n-dodecylhydrazine, cyclohexylhydrazine, phenylhydrazine, 4-methylphenylhydrazine, benzylhydrazine, 2-phenylethylhydrazine, 2-hydrazinoethanol, and acetohydrazine.

An amount of the reducing compound to be used may be from 0.1 to 10 mol, from 0.5 to 5 mol, or from 0.8 to 3 mol with respect to 1 mol of the copper compound.

Organic Solvent

The organic solvent is not particularly limited as long as it allows for performing a uniform reaction without inhibiting properties of a complex or the like generated by mixing the copper compound, the shape stabilizer, and the reducing compound. As the organic solvent, an organic solvent that exhibits compatibility with the reducing compound may be used. Examples of the organic solvent include alcohols such as 1-propanol, 2-propanol, butanol, pentanol, hexanol, heptanol, octanol, ethylene glycol, 1,3-propanediol, 1,2-propanediol, butyl cellosolve, ethyl carbitol, and butyl carbitol; and butyl carbitol acetate, ethyl carbitol acetate, and diethylene glycol diethyl ether. The organic solvents may be used alone or in combination of two or more.

When the organic solvent is used, any amount of the organic solvent to be used may be used as long as it allows uniform mixing of the copper compound, the shape stabilizer, and the reducing compound. The amount of the organic solvent to be used may be, for example, from 0.1 to 500 times by volume relative to a volume of the shape stabilizer.

The reduction reaction of the copper compound may be heated from the viewpoint of sufficient progress of the reaction. A reaction temperature may be from -20 to 140°C, from 25 to 120°C, or from 40 to 100°C. From the viewpoint of sufficient progress of the reaction, a reaction time may be from 20 to 360 minutes, from 30 to 300 minutes, or from 40 to 240 minutes.

When a content of a container in which the reduction reaction has been performed is a liquid (mixed liquid), a solid may be separated, for example, by centrifugation or the like. The obtained solid may be washed with an organic solvent, and may be obtained as a cake of copper particles by centrifugation or the like.

The washing may be performed as long as the shape stabilizer, the reducing compound, and the like are sufficiently removed, and a washing method is not particularly limited.

The organic solvent for washing may be an alcohol. Examples of the alcohol include ethanol, 1-propanol, 2-propanol, butanol, pentanol, hexanol, heptanol, octanol, ethylene glycol, 1,3-propanediol, 1,2-propanediol, diethylene glycol, butyl cellosolve, ethyl carbitol, and butyl carbitol. The organic solvents for washing may be used alone or in combination of two or more.

Paste Composition

The paste composition of the present disclosure contains the oxide-containing plate-shaped copper particle of the present disclosure described above.

A content of the copper particle in the paste composition may be from 10 to 95 mass%, from 20 to 90 mass%, or from 30 to 85 mass%.

In the present disclosure, a non-volatile content, which is a component excluding the organic solvent in the paste composition, is regarded as the content of the copper particle.

The paste composition may be diluted with an organic solvent from the viewpoint of handleability, viscosity, and the like during use.

From the viewpoint of dispersibility of the copper particle and volatility at the time of sintering of the paste composition, examples of the organic solvent include 1-propanol, 2-propanol, ethylene glycol, 1,3-propanediol, 1,2-propanediol, diethylene glycol, propylene glycol, dipropylene glycol, 1,4-butanediol, 3-methyl-1,5-pentanediol, glycerin, and polyethylene glycol. These organic solvents may be used alone or in combination of two or more. The organic solvent for dilution may be the same as the organic solvent for washing the copper particle.

The paste composition of the present disclosure may appropriately contain known additives which are applied to general electrically conductive pastes, if necessary, in addition to the copper particle, the organic solvent, and components derived from the production of the copper particle.

Examples of the additive include a thermosetting resin, a curing accelerator, stress reducing agents such as rubber and silicone, a coupling agent, an antifoaming agent, a surfactant, coloring agents such as a pigment and a dye, a polymerization inhibitor, and an antioxidant. These additives may be used alone or in combination of two or more.

The paste composition of the present disclosure can be prepared by kneading a mixture of the copper particle, the organic solvent, and the additive used as necessary with a kneading machine such as a disperser, a kneader, a three-roll mill, or a planetary mixer, and defoaming the kneaded product.

A cured product of the paste composition of the present disclosure includes a sintered body of the copper particles of the present disclosure, and has high thermal conductivity and high heat dissipation properties. Therefore, when the paste composition of the present disclosure is used as a bonding material for an element, a substrate of a heat dissipating member or the like, thermal conductivity of a device is improved, and dissipation properties of heat inside the device to the outside is improved. Therefore, use of the paste composition of the present disclosure makes it possible to stabilize operability of various products such as semiconductor devices, electrical components, and electronic components.

Semiconductor Device

The semiconductor device of the present disclosure is at least partially bonded by using the paste composition of the present disclosure described above. Examples of the semiconductor device include semiconductor devices in which a semiconductor element and a substrate serving as an element support member are bonded by using the paste composition. The paste composition may be used as a die bond.

Due to the use of the paste composition of the present disclosure for bonding, a bonding layer having high denseness and high bonding strength is formed. Since the bonding layer has a low rate of change in thermal resistance and high bonding reliability even when subjected to repeated temperature changes, a semiconductor device having stable operability can be obtained.

The semiconductor element may be a known semiconductor element, and examples thereof include transistors, diodes, wide bandgap semiconductor elements such as SiC and GaN, and light-emitting elements such as LEDs.

Examples of the element support member include a copper plate, a silver-plated copper plate, a pre-plated leadframe (PPF) plated with Ni/Pd, Ti/Pd/Au, Ni/Pd/Au, or the like, a glass epoxy plate, and a ceramic member.

The bonding strength of the bonding layer formed by using the paste composition for bonding may be not less than 20 MPa, not less than 30 MPa, or not less than 40 MPa from the viewpoint of sufficient bonding strength, though depending on the purpose of and target for bonding.

The bonding strength is die shear strength, and can be specifically measured by a method which will be described in the Examples.

The denseness of the bonding layer may be not less than 78%, not less than 80%, or not less than 82% from the viewpoint of good bonding strength and high bonding reliability. The denseness is a proportion of a sintered body portion in the bonding layer, and specifically can be measured by a method which will be described in the Examples.

Electrical Component and Electronic Component

The electrical component or the electronic component of the present disclosure is at least partially bonded by using the paste composition of the present disclosure described above. Examples of the electrical component or the electronic component include electrical components or electronic components in which a heat generating member and a heat dissipating member are bonded to each other by using the paste composition described above. The paste composition may be used as an adhesive for the heat dissipating member.

Due to the use of the paste composition of the present disclosure for bonding, a bonding layer having high denseness and high bonding strength is formed. Since the bonding layer has a low rate of change in thermal resistance and high bonding reliability even when subjected to repeated cooling and heating cycle (heat cycle) loads, it has high heat dissipation properties, can reduce temperature rise of the heat generating member, and can provide an electrical or electronic component having stable operability.

Examples of the heat generating member include optical pickups and power transistors. The heat generating member may be the semiconductor element or a member having the semiconductor element.

In addition, examples of the heat dissipating member include heat sinks and heat spreaders. The heat generating member and the heat dissipating member may be directly adhered to each other via the paste composition, or may be indirectly adhered to each other with another member having high thermal conductivity interposed therebetween.

EXAMPLE

The present disclosure will be specifically described through examples; however, the present disclosure is not limited in any way to these examples.

Production of Oxide-Containing Copper Particle

The compounds used in the production of the oxide-containing copper particle of each of the Examples and the Comparative Examples are as follows.

Copper compound

· FRC-D70: cuprous oxide; available from Furukawa Chemicals Co., Ltd.; specific surface area: 0.2 $m^2/g$
· FRC-D30: cuprous oxide; available from Furukawa Chemicals Co., Ltd.; specific surface area: 0.5 $m^2/g$
· FRC-05B: cuprous oxide; available from Furukawa Chemicals Co., Ltd.; specific surface area: 2.3 $m^2/g$

Amine Compound

· 4-Amino-1-butanol; available from Tokyo Chemical Industry Co., Ltd.
. 2-(2-Aminoethoxy)ethanol; available from Tokyo Chemical Industry Co., Ltd.
· 6-Amino-1-hexanol; available from Tokyo Chemical Industry Co., Ltd.
· 3-Amino-1-propanol; available from Tokyo Chemical Industry Co., Ltd.
· n-Octylamine; available from Tokyo Chemical Industry Co., Ltd.

Carboxylic Acid

· Hexanoic acid; available from Tokyo Chemical Industry Co., Ltd.
· Octanoic acid; available from Tokyo Chemical Industry Co., Ltd.
· Acetic acid; available from Tokyo Chemical Industry Co., Ltd.
· Decanoic acid; available from Tokyo Chemical Industry Co., Ltd.

Reducing Compound

· Hydrazine monohydrate; available from FUJIFILM Wako Pure Chemical Corporation Organic Solvent
· 1-Propanol; available from Tokyo Chemical Industry Co., Ltd.
· Ethanol; available from Tokyo Chemical Industry Co., Ltd.
· Diethylene glycol: available from Tokyo Chemical Industry Co., Ltd.

Example 1

10 mmol of Cuprous oxide (FRC-D70), 20 mmol of 4-amino-1-butanol, 20 mmol of hexanoic acid, 10 mmol of hydrazine monohydrate, and 400 mL of 1-propanol were placed in a 2000 mL volume round-bottomed flask, heated in an oil bath at 80°C while stirring at 250 rpm, and mixed for 180 minutes. The obtained mixed liquid was centrifuged (25°C, 10000 rpm, 15 minutes; hereinafter, the same conditions), and the supernatant liquid was removed. Ethanol was added to the residue, and the mixture was stirred and washed for 10 minutes with a vacuum planetary centrifugal mixer (25°C, 1000 rpm), and then centrifuged, and the supernatant liquid was removed. This operation was repeated four times. Furthermore, ethanol was changed to diethylene glycol, and the same operation as the above-described washing, centrifugation, and removal of the supernatant liquid was repeated twice to obtain an oxide-containing copper particle cake.

Examples 2 to 4 and Comparative Examples 1 and 2

Each oxide-containing copper particle cake was obtained by the same operation as in Example 1 except that the raw material components shown in Table 1 were used.

Measurement and Evaluation of Oxide-Containing Copper Particle The oxide-containing copper particles (cakes) produced in the Examples and the Comparative Examples were subjected to the following measurement and evaluation. The evaluation results are shown in Table 1.

X-Ray Diffraction (XRD) Measurement

The oxide-containing copper particle cake was applied onto a glass plate in a thickness of 200 $\mu$m, and XRD measurement was performed with an X-ray diffractometer ("SmartLab SE", available from Rigaku Corporation; CuK$\alpha$ rays, concentration method). The obtained XRD pattern was fitted with a split pseudo-Voigt function.

Mass Ratio of Each of $Cu_{64}O$ and $Cu_2O$

By the XRD pattern analysis, each of the contents of $Cu_{64}O$ and $Cu_2O$ relative to 100 mass% of the total content of Cu, $Cu_{64}O$, and $Cu_2O$ was determined by the reference intensity ratio (RIR) method. Specifically, each content was calculated by the RIR method using an integrated intensity obtained by subtracting a background intensity and each RIR value (Cu: 8.86, $Cu_{64}O$: 4.89, $Cu_2O$: 8.28) for the strongest curve of each component (Cu (111), $Cu_{64}O$ (044), and $Cu_2O$ (111)).

Crystallite Diameter of Cu (111)

The crystallite diameter C of Cu (111) was calculated from the half width (full width at half maximum: FWHM) $\beta$ and the Bragg angle $\theta$ (1/2 of the diffraction angle 2$\theta$) of the Cu (111) peak in the XRD pattern according to the following Scherrer equation.

$$C = K \cdot \lambda / (\beta \cdot \cos\theta)$$

In the equation, Scherrer constant: K = 0.94, characteristic X-ray wavelength of CuK$\alpha$ ray: $\lambda$ = 0.15418 [nm].

A sample obtained by heating the oxide-containing copper particle cake applied in a glass shape at 200°C for 1 hour in a nitrogen atmosphere was also subjected to XRD measurement in the same manner to determine the crystallite diameter of Cu (111).

Table 1 shows the crystallite diameter (C1) before heating (at room temperature), the crystallite diameter (C2) after heating (at 200°C), and the ratio C2/C1 therebetween.

Scanning Electron Microscope (SEM) Observation

The oxide-containing copper particle cake was applied to a brass sample stand to which a carbon tape was attached, and dried at 90°C for 3 hours in a nitrogen atmosphere, and a sample was produced.

This sample was observed with an SEM (Schottky field emission scanning electron microscope "JSM-F100", available from JEOL Ltd.; acceleration voltage: 15 kV, magnification: 100000 times; the same applies hereinafter). The lengths of 200 particles in an SEM image were measured, and the thicknesses and the major axes of the particles were determined. Table 1 indicates medians of the thicknesses and the major axes.

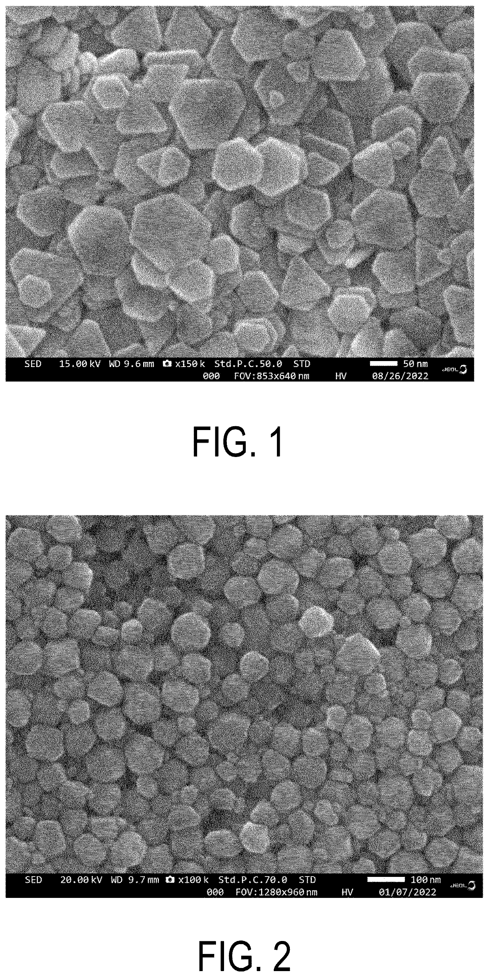

The SEM images of the samples of Example 4 and Comparative Example 2 are shown in FIGs. 1 and 2, respectively, as representative examples.

Characteristic Evaluation of Sintered Body

The sintered bodies of the oxide-containing copper particles produced in the Examples and the Comparative Examples were subjected to the following measurement and evaluation. These evaluation results are also shown in Table 1.

Bonding Strength

The oxide-containing copper particles (cakes) produced in the Examples and the Comparative Examples were diluted with diethylene glycol, and paste compositions having a non-volatile content of 80 mass% were prepared.

Using the prepared paste compositions, a Ti/Pd/Au-plated aluminum nitride piece (3 mm × 3 mm, 200 μm thick) was adhered to a Ni/Pd-plated copper substrate, and heating was performed at 200°C for 60 minutes in a nitrogen atmosphere (containing 3 vol% of hydrogen) to sinter the copper particles, and bonding test pieces (test pieces without a sealing resin) were produced.

The die shear strength (bonding strength) of each of the bonding test pieces was measured by using a bonding strength tester ("4000Plus Bond Tester", available from Nordon DAGE; room temperature (25°C), distance from the substrate to the loading fixture: 0.15 mm, loading rate: 30 mm/min).

Denseness

The test piece without the sealing resin was embedded in an epoxy resin and cut in the thickness direction to obtain a sample. The sample was observed using SEM, and an area proportion of a sintered body portion in a binarized image of a cross section of the bonding layer was determined, and defined as the denseness.

Cooling and heating cycle test

Using the paste composition, a Ti/Au-plated silicon chip (3 mm × 3 mm, 200 μm thick) was adhered to a Ni/Pd/Au-plated die pad (4 mm × 4 mm) of a QFP (Quad Flat Package) frame and heated at 200°C for 60 minutes in a nitrogen gas atmosphere (containing 3 vol% of hydrogen), and the copper particles were sintered. The sintered product was mold-sealed with an epoxy resin for sealing ("KE-G3000D", available from KYOCERA Corporation), and a bonding test piece (a test piece with the sealing resin) was produced.

A cooling and heating cycle test (1 cycle: from -40°C to 120°C/30 minutes, 2000 cycles) was performed on the test piece without the sealing resin and the test piece with the sealing resin. The rate of change in thermal resistance of the bonding portion before and after the test was measured by a transient thermal resistance measuring device ("Simcenter T3Ster", available from Siemens K.K.). Table 1 shows the rate of change in thermal resistance. A lower rate of change indicates a higher bonding reliability. When the rate of change exceeded 10%, the bonding reliability was low and evaluated as poor.

[Table 1]

Table 1

| | | Example 1 | Example 2 | Example 3 | Example 4 | Comparative Example 1 | Comparative Example 2 |
|---|---|---|---|---|---|---|---|
| Raw material component [mmol] | | | | | | | |
| Copper compound | Cuprous oxide (FRC-D70) | 10 | - | 10 | 10 | - | - |
| | Cuprous oxide (FRC-D30) | - | 10 | - | - | - | - |
| | Cuprous oxide (FRC-05B) | - | - | - | - | 10 | 10 |
| Amine compound | 4-Amino-1-butanol | 20 | - | - | - | - | - |
| | 2-(2-Aminoethoxy)ethanol | - | 20 | 20 | - | - | - |
| | 6-Amino-1-hexanol | - | - | - | 20 | - | - |
| | 3-Amino-1-propanol | - | - | - | - | 20 | - |
| | n-Octylamine | - | - | - | - | - | 20 |
| Carboxylic acid | Hexanoic acid | 20 | - | - | - | - | - |
| | Octanoic acid | - | 20 | 20 | 20 | - | - |
| | Acetic acid | - | - | - | - | 20 | - |
| | Decanoic acid | - | - | - | - | - | 20 |
| Reducing compound | Hydrazine monohydrate | 10 | 10 | 10 | 10 | 10 | 10 |
| Evaluation | | | | | | | |
| Copper particle | Content [mass%] Cu$_{64}$O | 23.1 | 16.5 | 6.8 | 3.5 | 0.1 | 0.3 |
| | Content [mass%] Cu$_2$O | 4.3 | 3.2 | 1.1 | 0.8 | 0.7 | 0.9 |
| | Cu (111) Crystallite diameter Room temperature (C1) [nm] | 9.5 | 8.5 | 13.2 | 15.8 | 48.9 | 35.1 |
| | Cu (111) Crystallite diameter 200°C (C2) [nm] | 58.0 | 58.4 | 67.4 | 69.3 | 52.2 | 56.3 |
| | C2/C1 | 6.1 | 6.9 | 5.1 | 4.4 | 1.1 | 1.6 |
| Thickness [nm] | | 19 | 25 | 11 | 18 | 202 | 72 |
| Major axis [nm] | | 80 | 92 | 81 | 117 | 202 | 72 |
| Bonding strength [MPa] | | 41 | 45 | 70 | 76 | 15 | 10 |

(continued)

|  |  | Example 1 | Example 2 | Example 3 | Example 4 | Comparative Example 1 | Comparative Example 2 |
|---|---|---|---|---|---|---|---|
| Raw material component [mmol] |  |  |  |  |  |  |  |
| Denseness [%] |  | 84 | 85 | 88 | 89 | 75 | 72 |
| Rate [%] of change in thermal resistance (Cooling and heating cycle test) | Without sealing resin | 7 | 5 | 2 | 2 | 125 | 186 |
|  | With sealing resin | 5 | 2 | 1 | 1 | 113 | 186 |

The oxide-containing copper particles (Examples 1 to 4) in which the content of $Cu_{64}O$ was in the range of from 2.1 to 25.0 mass% relative to 100 mass% of the total content of Cu, $Cu_2O$, and $Cu_{64}O$ had a plate-shaped particle shape (see FIG. 1), whereas the copper particles (Comparative Examples 1 and 2) in which the content of $Cu_{64}O$ was out of the range had a substantially spherical particle shape (see FIG. 2).

In the copper particles in Comparative Examples 1 and 2, the crystallite diameter of Cu (111) was more than 30.0 nm in an unheated state (room temperature), which was larger than those in Examples 1 to 4, and the change before and after heating at 200°C was small. For this reason, it is presumed that the bonding layers formed using the paste compositions of Comparative Examples 1 and 2 had low denseness, did not acquire sufficient bonding strength, and had low bonding reliability.

It was found that the paste compositions of Examples 1 to 4 can form a bonding layer having high denseness, high bonding strength, and high bonding reliability.

**Claims**

1. A copper oxide-containing plate-shaped copper particle comprising Cu, $Cu_2O$, and $Cu_{64}O$, wherein a content of $Cu_{64}O$ is from 2.1 to 25.0 mass% relative to 100 mass% of a total content of Cu, $Cu_2O$, and $Cu_{64}O$.

2. The oxide-containing plate-shaped copper particle according to claim 1, wherein a content of $Cu_2O$ is not more than 5.0 mass% relative to 100 mass% of the total content of Cu, $Cu_2O$, and $Cu_{64}O$.

3. The oxide-containing plate-shaped copper particle according to claim 1 or 2, wherein, when the copper particle is heated at 200°C in a nitrogen atmosphere, a ratio (C2/C1) of a crystallite diameter (C2) of Cu (111) as measured by X-ray diffraction after heating to a crystallite diameter (C1) of Cu (111) as measured by X-ray diffraction before heating is not less than 2.0.

4. The oxide-containing plate-shaped copper particle according to claim 3, wherein the crystallite diameter (C2) is not less than 55.0 nm.

5. The oxide-containing plate-shaped copper particle according to any one of claims 1 to 4, wherein the oxide-containing plate-shaped copper particle has a thickness of from 5 to 50 nm and a major axis of from 30 to 300 nm, and the major axis is larger than the thickness.

6. A paste composition comprising the oxide-containing plate-shaped copper particle according to any one of claims 1 to 5.

7. A semiconductor device which is at least partially bonded by using the paste composition according to claim 6.

8. An electrical component which is at least partially bonded by using the paste composition according to claim 6.

9. An electronic component which is at least partially bonded by using the paste composition according to claim 6.

SED    15.00 kV  WD 9.6 mm  ⬜ x150 k  Std.P.C.50.0  STD                         50 nm   JEOL
                            000   FOV:853x640 nm           HV      08/26/2022

## FIG. 1

SED    20.00 kV  WD 9.7 mm  ⬜ x100 k  Std.P.C.70.0  STD                        100 nm   JEOL
                            000   FOV:1280x960 nm          HV      01/07/2022

## FIG. 2

## INTERNATIONAL SEARCH REPORT

| International application No. |
| --- |
| **PCT/JP2023/013460** |

### A. CLASSIFICATION OF SUBJECT MATTER

***B22F 1/00***(2022.01)i; ***B22F 1/054***(2022.01)i; ***B22F 1/06***(2022.01)i; ***B22F 1/07***(2022.01)i; ***B22F 1/102***(2022.01)i;
***B22F 1/103***(2022.01)i; ***B22F 1/16***(2022.01)i; ***B22F 7/08***(2006.01)i; ***B22F 9/00***(2006.01)i; ***B22F 9/20***(2006.01)i;
***B82Y 30/00***(2011.01)i; ***B82Y 40/00***(2011.01)i; ***C22C 1/04***(2023.01)i; ***C22C 32/00***(2006.01)i; ***H01L 21/52***(2006.01)i
FI:    B22F1/00 L; B22F1/054; B22F1/06; B22F1/07; B22F1/102; B22F1/103; B22F1/16; B22F7/08 C; B22F9/00 B;
B22F9/20 E; B82Y30/00; B82Y40/00; C22C1/04 A; C22C32/00 B; H01L21/52 E

According to International Patent Classification (IPC) or to both national classification and IPC

### B. FIELDS SEARCHED

Minimum documentation searched (classification system followed by classification symbols)

B22F1/00; B22F1/054; B22F1/06; B22F1/07; B22F1/102; B22F1/103; B22F1/16; B22F7/08; B22F9/00; B22F9/20;
B82Y30/00; B82Y40/00; C22C1/04; C22C32/00; H01L21/52

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 2020-035979 A (KYOCERA CORP) 05 March 2020 (2020-03-05)<br>     claims 1-7, paragraphs [0088]-[0108], tables 1-2 | 1-9 |
| X | WO 2022/045252 A1 (NATIONAL UNIVERSITY CORPORATION HOKKAIDO UNIVERSITY) 03 March 2022 (2022-03-03)<br>     claims 1-10, paragraphs [0033]-[0093], table 1 | 1-9 |
| A | JP 2020-029392 A (NATIONAL UNIVERSITY CORPORATION HOKKAIDO UNIVERSITY) 27 February 2020 (2020-02-27)<br>     entire text | 1-9 |
| A | KR 10-2011-0008386 A (INDUSTRY-ACADEMIC COOPERATION FOUNDATION, DANKOOK UNIVERSITY) 27 January 2011 (2011-01-27)<br>     entire text | 1-9 |

☑ Further documents are listed in the continuation of Box C.      ☑ See patent family annex.

| | |
| --- | --- |
| *      Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **02 May 2023** | **16 May 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2023/013460**

## C. DOCUMENTS CONSIDERED TO BE RELEVANT

| Category* | Citation of document, with indication, where appropriate, of the relevant passages | Relevant to claim No. |
|---|---|---|
| A | JP 2020-084242 A (KYOCERA CORP) 04 June 2020 (2020-06-04)<br>entire text | 1-9 |
| A | JP 2016-196705 A (KYORITSU KAGAKU SANGYO) 24 November 2016 (2016-11-24)<br>entire text | 1-9 |

Form PCT/ISA/210 (second sheet) (January 2015)

### INTERNATIONAL SEARCH REPORT
**Information on patent family members**

International application No.

**PCT/JP2023/013460**

| Patent document cited in search report | | | Publication date (day/month/year) | Patent family member(s) | | | Publication date (day/month/year) |
|---|---|---|---|---|---|---|---|
| JP | 2020-035979 | A | 05 March 2020 | WO | 2020/044982 | A1 | |
| | | | | TW | 202014259 | A | |
| WO | 2022/045252 | A1 | 03 March 2022 | CN | 115461173 | A | |
| JP | 2020-029392 | A | 27 February 2020 | (Family: none) | | | |
| KR | 10-2011-0008386 | A | 27 January 2011 | (Family: none) | | | |
| JP | 2020-084242 | A | 04 June 2020 | WO | 2020/105497 | A1 | |
| | | | | TW | 202026074 | A | |
| JP | 2016-196705 | A | 24 November 2016 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020029392 A

- WO 2022045252 A